# EUROPEAN PATENT SPECIFICATION

(11) **EP 0 325 379 B1**
(45) Date of publication and mention of the grant of the patent: **19.03.1997**
(21) Application number: 89300322.8
(22) Date of filing: 13.01.1989
(51) Int. Cl.: H03H 7/01, H03H 7/09, H03H 7/42, H02M 1/12

(54) **Value determining method for line filter and its components**
Methode zur Wertbestimmung für Leitungsfilter und zugehörige Komponenten
Méthode pour déterminer la valeur pour filtre de réseau et ses composants

(30) Priority: 14.01.1988 JP 6688/88; 31.08.1988 JP 217808/88
(43) Date of publication of application: 26.07.1989
(73) Proprietor: KABUSHIKI KAISHA TOSHIBA, Kawasaki-shi, Kanagawa-ken 210 (JP)
(72) Inventor: Okochi, Sadao c/o Patent Division, Minato-ku Tokyo 105 (JP); Kasama, Norio c/o Patent Division, Minato-ku Tokyo 105 (JP); Matsuya, Hideji c/o Patent Division, Minato-ku Tokyo 105 (JP)
(74) Representative: Freed, Arthur Woolf

(56) References cited:
- EP-A- 0 142 809
- EP-A- 0 186 524
- US-A- 4 342 013
- G.C. TEMES et al.: "Modern filter theory and design", 1st edition 1973, pages 222-224, chapter 6, John Wiley & Sons, Inc., New York, US

## Description

The present invention relates to a value determining method for a line filter and its components which attenuate noise signals supplied from electronic appliances having built-in high-frequency noise sources (referred to as a noise source appliance) such as switching power source.

In general, noise signals spread from a noise source appliance to the external through a power line. When these signals are received by a pseudo-power circuit network (referred to as an LISN), their noise level (referred to as a noise terminal voltage) must be less than or equal to a legally-regulated value.

For meeting the requirement, the prior art provides a line filter on the power entry side of the noise source appliance.

The line filter can effectively attenuate normal mode and common mode components, but it is considerably bulky because of a built-in coil unless it is much devised.

With recent increase of demands for small or lightweight appliances, the line filter has been required to include smaller, more lightweight and cheaper elements whose characteristic values must be as low as possible.

In the prior arts, however, engineer's experience and knowledge have significantly determined how to assemble elements for producing a line filter as noise source fundamental frequency components are supplied to the line filter. Comparing an optimal line filter, therefore, has been quite burdensome. It often results in producing a bulky or expensive line filter.

The foregoing noises have a common mode noise flowing between a power line and the earth and a normal mode noise flowing between power lines. In both cases, to attenuate the noise level, the line filter is inserted between a power source and a power line.

A typical line filter comprises balun coils (balanced-to-unbalanced transformer) respectively providing two set of windings on a ring core, these balun coils being longitudinally connected, capacitors inserted between a power source and a power line on the load side of each coil (referred to as X capacitors), and capacitors inserted between the power line and the earth on the load side of each coil (referred to as Y capacitors).

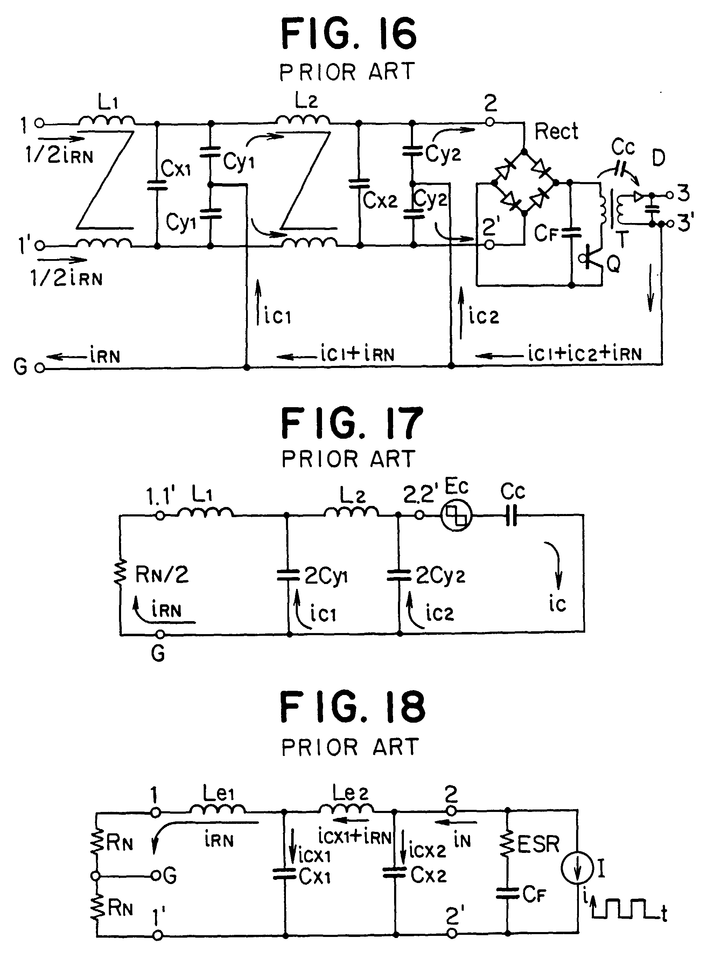

Fig. 16 is a circuit diagram showing the arrangement of a power source circuit employing this type of line filter.

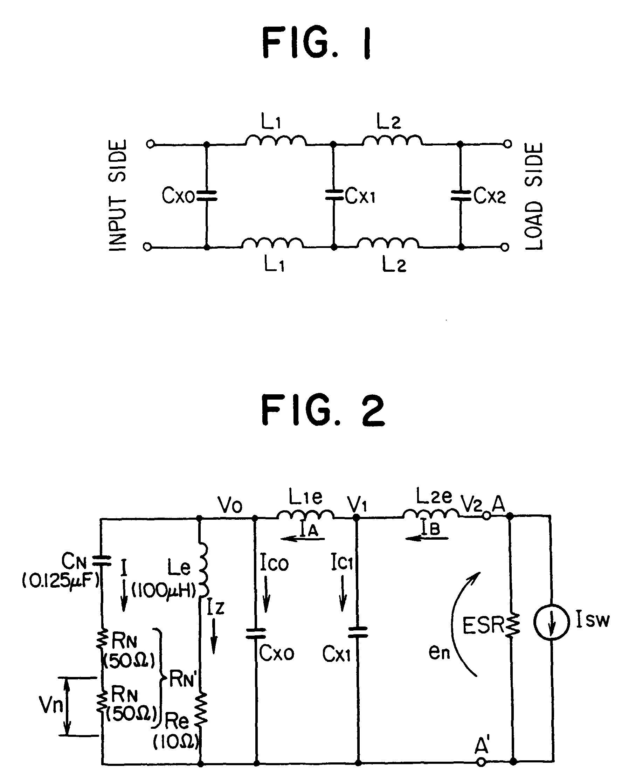

In Fig. 16, 1 and 1' denote input terminals, 2 and 2' denote output terminals, G denotes an earth terminal, Rec denotes a diode bridge for rectifying alternate current into direct current, and C_{F} denotes a capacitor for smoothing the rectified voltage.

T denotes a transformer consisting of a primary and a secondary coils, Q denotes a switching transistor, D denotes a diode for rectifying an indicative voltaqe on the secondary coil of the transformer T.

L₁, L₂ denote balun coils, Cₓ₁, Cₓ₂ denote X capacitors connected between power lines, and C_{y1}, C_{y2} denote Y capacitors connected between the power line and the earth.

This circuit feeds direct current from the output terminals 3, 3' of the secondary coil to the load. The output terminal 3' is normally connected to the earth for stabilizing operation of an electric circuit.

C_{c} means distribution capacitance generated between the primary coil and the secondary coil of the transformer T and serves to pass the common mode noise generated by the transistor Q switching to the sencondary side. The current path of the common mode noise is shown by arrows.

As set forth above, the noises can be grouped into common mode components and normal mode ones. The current shown in Fig. 16 has equivalent circuits shown in Figs. 17 and 18, which serve to attenuate these two types of noise component.

Fig. 17 is a view showing an equivalent circuit of the circuit shown in Fig. 16, which is dedicated for common mode noises.

In Fig. 17, Ec denotes a common mode noise source, R_{N} denotes impedance (generally, R_{N} = 50Ω) of a pseudo-power source circuit (referred to as an LISN) network representing equivalent impedance of an AC power line. The other like references denote the like elements shown in Fig. 16.

The Y capacitor C_{y2} recovers most common mode noise emerging through the distribution capacitance C_{c} as i_{c2}. The Y capacitor C_{y1} recovers most of the leaked noise as i_{c1}. The remaining noise flows into the exterior as iRN.

To attenuate the noise components of lower harmonics, the Y capacitor C_{y2} must have larger capacitance. However, it is subject to restrictions on safety standards for leak current since it is connected to the earth.

In place of providing the Y capacitor C_{y2} with larger capacitance, therefore, the balun coil L₂ must have larger inductance. However, the balun coil L₂ passes high-frequency noises, because it is a parasitic element and thus has larger distribution capacitance.

In this case, by connecting the balun coil L₁ having smaller distribution capacitance to the input side of the balun coil L₂, it is possible to suppress the common mode noises of a high frequency.

In addition, the present inventors have already developed the method for effectively reducing the common mode components on the assumption of L₁ < L₂ and C_{y1} < C_{y2} in the foregoing circuit (as disclosed in the Official Gazettes of Japanese Patent Laid-Open No. 61-157111 and U.S. Patent No. 4,667,173).

Fig. 18 is a view showing an equivalent circuit of the circuit shown in Fig. 16, which is dedicated for normal mode noises.

In Fig. 18, I denotes switching current, which generates the normal mode noises and whose waveform is, as an example, shown right. C_{F} denotes a smoothing capacitor which generates the switching current I. ESR denotes an equivalent series resistor which is a parasitic element of the capacitor C_{F}.

In general, the capacitor C_{F} generates a far larger voltage than ESR, causing the normal mode noise.

Lₑ₁ and Lₑ₂ respectively denote leak inductance of the balun coils L₁ and L₂, which brings about impedance for suppressing the normal mode noises. R_{N} denotes equivalent impedance of the LISN.

The noise current generated in ESR becomes the normal mode noise i_{N} which counter-flows from the line filter to the power source. Most of the noise i_{N} is recovered as i_{cx1} by the X capacitor Cₓ₁, but is partially leaked from it. The leaked noise counter-flows to the LISN through an AC-power line and is measured as noise.

The foregoing conventional line filter includes a capacitor Cₓ₂ being connected in parallel with the smoothing capacitor C_{F} (several hundreds µF). Yet, the capacitor Cₓ₂ has electrostatic capacitance of 0.1 to 0.5 µF, which is negligible in comparison with the capacitance of the capacitor C_{F}.

At this time, the capacitor Cₓ₂ has the following impedance in association with switching fundamental waves or lower harmonic noises:${\text{|1/ω C}}_{\text{x2}} \text{|>>} \sqrt{{\text{ESR}}^{\text{2}} {\text{+ (1/ω C}}_{\text{F}} {\text{)}}^{\text{2}}}$ It indicates that the capacitor does not effectively work for attenuating the normal mode noises.

This invention is designed to overcome the foregoing shortcoming, and it is an object of this invention to provide a line filter which is excellent in an attenuating effect.

The invention provides a line filter as defined in the independent claims.

By minimising the inductances this invention can offer a small and inexpensive line filter, capable of filtering normal mode noise.

Preferred embodiments of the invention will now be described and compared with conventional filters, with reference to the accompanying schematic drawings, in which:-
Fig. 1 is a view showing arrangement of a line filter for attenuating the normal mode noises;
Fig. 2 is a view showing an equivalent circuit for obtaining an optimal circuit constant of the line filter;

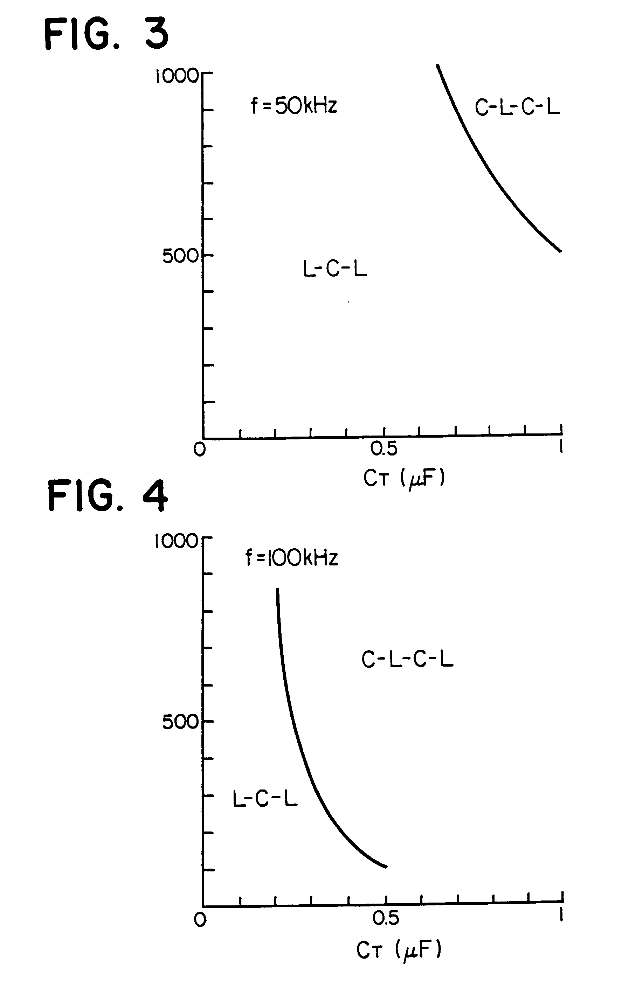

Figs. 3 and 4 are graphs of total capacitance CT against total inductance LT for describing the border on which one of two types of filters should be properly used;

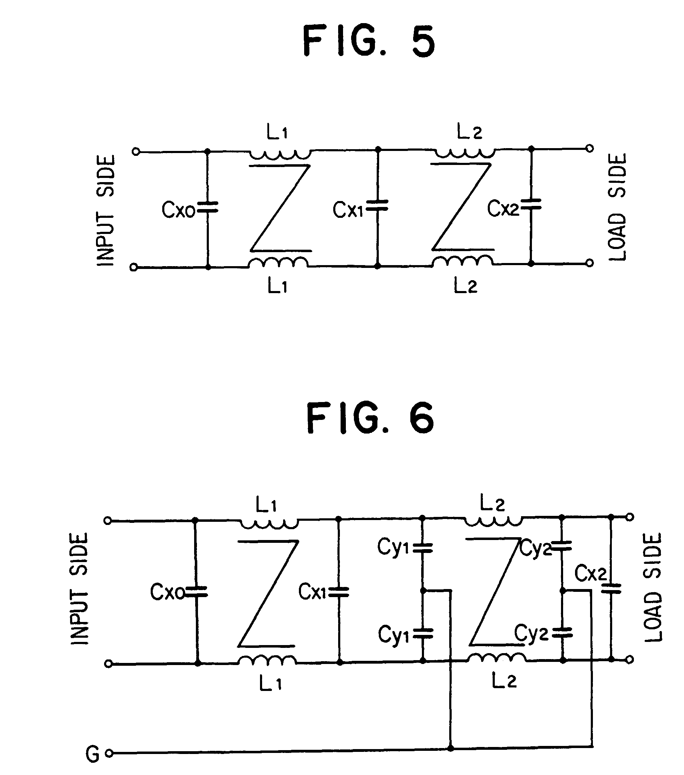

Fig. 5 is a view showing an arrangement of a line filter for attenuating common mode noises;
Fig. 6 is a view showing an arrangement of combination of the line filter for attenuating normal mode noises with that for attenuating common mode noises;

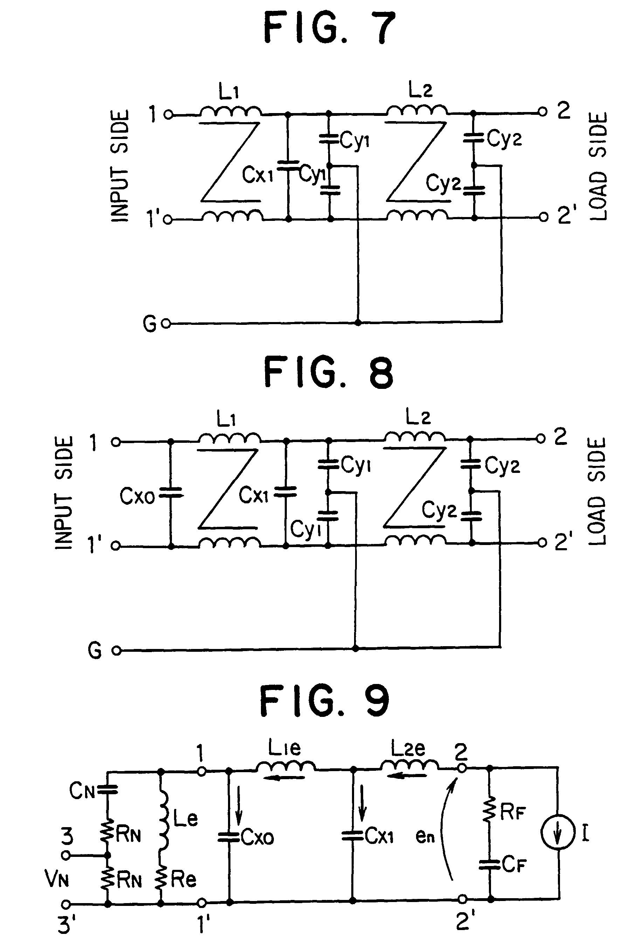

Fig. 7 is a circuit diagram showing a line filter;
Fig. 8 is a view showing an arrangement of a circuit to be compared with circuit shown in Fig. 7;
Fig. 9 is a view showing an equivalent circuit of the circuit shown in Fig. 8, which works for normal mode noises;

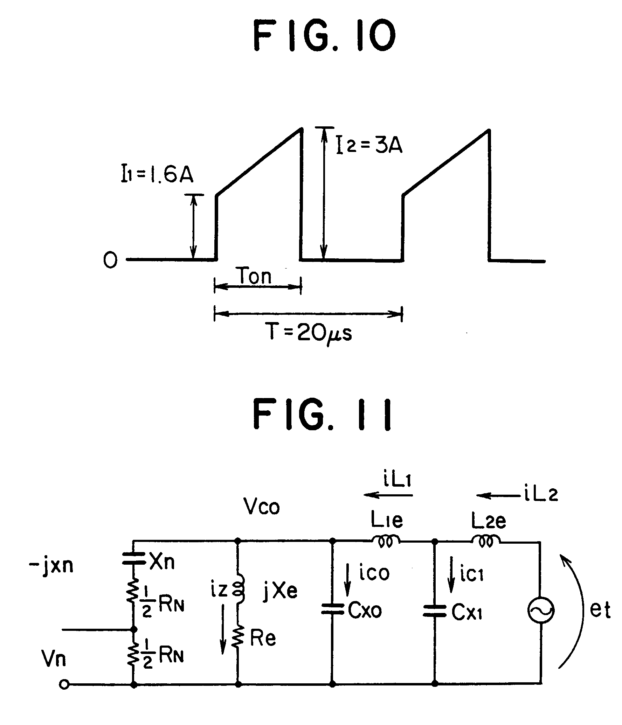

Fig. 10 is a view showing a waveform of power current flowing through the circuit shown in Fig. 9;

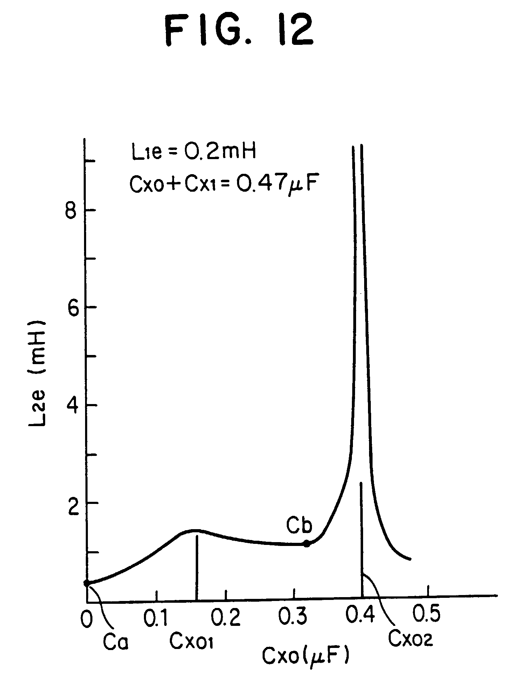

Fig. 11 is a view showing the definition of current and voltage in the circuit shown in Fig. 9;

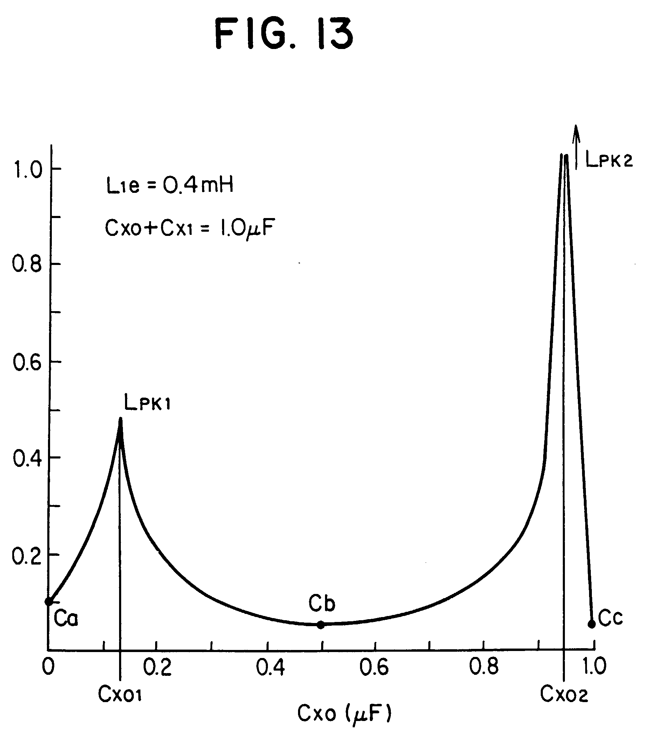

Figs. 12 and 13 are graphs showing the inductances of the choke coils;

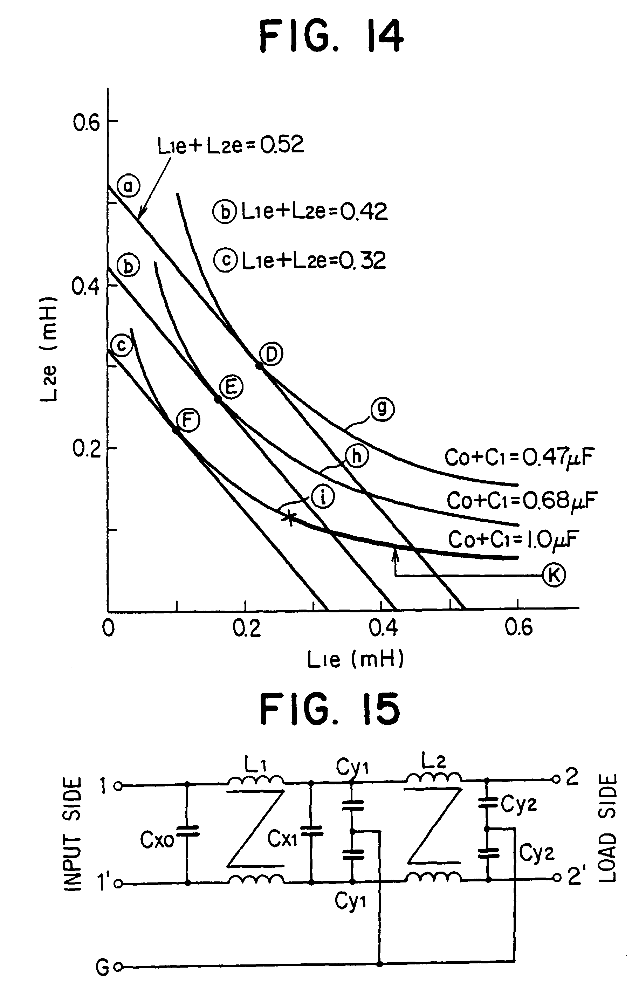

Fig. 14 is a view showing the relation of a minimal desired value of choke coil L₂ₑ with a choke coil L₂ₑ;
Fig. 15 is a circuit diagram showing the other line filter;
Fig. 16 is a view showing one example of power source arrangement employing a conventional line filter;
Fig. 17 is a view showing an equivalent circuit of the circuit shown in Fig. 16, which works for common mode noises; and
Fig. 18 is a view showing an equivalent circuit of the circuit shown in Fig. 16, which works for common mode noises.

Fig. 1 show an arrangement of a line filter for attenuating normal mode noises.

L1 and L2 denote inductors inserted between an input side and a load side of a power line, and CX0, CX1 and CX2 denote capacitors connected between a pair of power lines.

Fig. 2 shows an equivalent circuit for obtaining an optimal circuit constant of this line filter.

CN denotes a capacitor, which is one component of a pseudo-power source circuit network (referred to as LISN), RN denotes a resistor, which is one component of the LISN or internal impedance of a jamming wave level detector Rx, Le denotes an inductance of all components composing the LISN, Re denotes resistance of all components composing the LISN, CX0, CX1 denote capacitors for attenuating normal mode noises, L1e, L2e denote inductors for attenuating normal mode noises, and ESR denotes an equivalent series resistor, which corresponds to the equivalent components of an electrostatic capacitor for smoothing.

Further, ISW denotes current produced by switching elements contained in a switching power source, en denotes an equivalent voltage source representing switching noises caused in the ESR, Vn denotes a noise terminal voltage caused in the resistor Rn (to be measured by the jamming wave level detector), I denotes equivalent current produced when the noise terminal voltage Vn is set on the regulated value of the VDE standards, VDE0871, Class B, Vo denotes a voltage caused in a branch path consisting of a capacitor Cn and the resistor Rn, that is, VO = 2RnI + {1/(jω Cn)}· I, IZ denotes current flowing through Le and Re, Ico denotes current flowing through CX0, Ic1 denotes current flowing through CX1, IA denotes current flowing through the inductor Lie, IB denotes current flowing through the inductor L2e, and V2 denotes a voltage caused between A-A'.

Moreover, en = V2 is given when the noise terminal voltage Vn keeps the regulated value of VDE0871 and Vn is equal to the regulated value.

### (1) Normal mode noise source

The source is a noise voltage which serves to cause switching current at both ends of input side smoothing capacitor.

The noise voltage consists of internal components of the switching current produced on the electrostatic capacitance of the smoothing capacitor and voltage drop components caused by the ESR. If an aluminum electrolytic capacitor is employed, the noise voltage is regarded to mainly consist of the ESR components.

### (2) Filter circuit

A two-stage filter using two Ls is required to adapt the noise terminal voltage to the regulated value of the VDE standards VDE0871, Class B.

Herein, the combinations of CX0 - L1 - CX1 - L2 and L1 - CX1 - L2 are considered.

### (3) LISN equivalent circuit

The LISN regulated on the VDE standards VDE0876 is considered.

In order to obtain the LISN equivalent constant, it is possible to separate the elements into RN elements, CN elements and all elements except them, RN and CN elements being serially connected to an LISN jamming waves level detector (RX).

The elements except RN and CN ones are grouped as equivalent resistors Le and Re.

### (4) Equivalent circuit used for calculation

Fig. 2 shows an equivalent circuit used for calculation for determining an attenuation effect the filter can offer.

The source is a power source, but it (the section in the right side of the line A-A') should be replaced with an equivalent voltage source en.

### (5) Studying noise characteristics

The filter element should be selected from the following three cases.
1) CX0 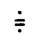 CT/2, CX1 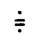 CT/2,
   CX0 + CX1 = CT
2) CX0 = 0, CX1 = CT
3) CX0 = CT, CX1 = 0

For each case, how to arrange L1, L2, CX0 and CX1 was studied for obtaining the maximum attenuation effect under the condition of LT = L1 + L2 (constant) and when LT = constant.

Then, 2) and 3) cases will be compared.

Assume that 1(A) normal mode noise current flows through RN for obtaining damping capacity of a filter. The current should have a value so that Vn may be same with the VDE regulated value.

At this time, it is necessary to obtain the noise voltage V2 between the load terminals of the filter. (Vn keeps a regulated value of VDE0871, Class B.)${\text{V2 = {(RN'I - X}}_{\text{1}} {\text{I}}_{\text{1}} {\text{i) - X}}_{\text{2}} {\text{(I}}_{\text{1}} {\text{i + IC1i)} + j{(X}}_{\text{1}} {\text{I}}_{\text{1}} \text{r -} {\text{I/Yn + X}}_{\text{2}} {\text{(I}}_{\text{1}} \text{r + IC1r)}}$ where RN' = 2RN = real number, and i = imaginary number.

Further, assuming that IC1 = CX1 current; I₁ = L₁ current; X1, X2 = L1, L2 reactances respectively (= ω L, ωL) Yn, Y0, Y1 = Cn, CX0, CX1 admittances respectively (=ω Cn, ωCX0, ωCX1); X₁ + X₂ = XT (= constant), and Y0 + Y1 = YT (=constant), the formulas representing V2r and V2i are as follows:${\text{V2r = RnI - XT (Y0RN' - IZi)I - (XT - X}}_{\text{1}} \text{)(XT - Y0){RN'} {\text{- X}}_{\text{1}} \text{(Y0RN' - IZi)} I}$$\text{V2i = XT (1 + IZr + Y0/Yn)I} {\text{+ (XT - X}}_{\text{1}} {\text{)(YT - Y0){1/Yn - X}}_{\text{1}} \text{(1 + IXr + Y0/Yn)}I - I/Yn}$ where IZr and IZi denote a real number and an imaginary number of a formula in which z represents current flowing through a branch paths of Le and Re, as shown below;${\text{IZr = (ReRn - XeXn) / (Re}}^{\text{2}} {\text{+ Xe}}^{\text{2}} \text{)}$${\text{IZi = (RnXe - Re/Yn) / (Re}}^{\text{2}} {\text{+ Xe}}^{\text{2}} \text{)}$

V2 is equal to an allowable value of the source noise voltage en. Assuming that;$\text{en =} \sqrt{{\text{V2r}}^{\text{2}} {\text{+ V2i}}^{\text{2}}}$$\text{K = en/Vn =} \sqrt{{\text{V2r}}^{\text{2}} {\text{+ V2i}}^{\text{2}}} \text{/ (RN·I)}$ and the damping capacity IL of a filter IL = 20 logk, optimising the line filter for normal mode noises results in selecting circuit elements so that IL is maximized under the conditions of CT = constant and LT = constant.

For making the conditions less complicated, it is necessary to substitute the conditions of the formulas 1) to 3) for the formulas 4) and 5).
(i) Y0 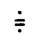 1/2 YT, Y1 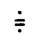 1/2 YT (the case 1))
   For representing K using X₁, substitute the formula 7) for the formulas 4) and 5) and then the result for the formula 6), resulting in providing the following formulas;${\text{K}}^{\text{2}} {\text{RN}}^{\text{2}} {\text{= A0X}}_{\text{1}} {}^{\text{4}} {\text{+ A1X}}_{\text{1}} {}^{\text{3}} {\text{+ A2X}}_{\text{1}} {}^{\text{2}} {\text{+ A3X}}_{\text{1}} \text{+ A4}$${\text{A0 = Mr}}^{\text{2}} {\text{+ Mi}}^{\text{2}}$$\text{A1 = -2 (MrNr + MiNi)}$${\text{A2 = Nr}}^{\text{2}} {\text{+ Ni}}^{\text{2}} \text{- 2MrPr + 2MiPi}$$\text{A3 = 2(NrPr + NiPi)}$${\text{A4 = Pr}}^{\text{2}} {\text{+ Pi}}^{\text{2}}$$\text{Mr = (YT/2)(YT Rn/2) - IXi}$$\text{Nr = YT Rn/2} \text{+ (YT/2)XT (YT Rn/2 - IZi)}$$\text{Pr = RN(1 - YT XT) + XT IZi}$$\text{Mi = (YT/2)(1 + IZr + YT/2 Yn)}$$\text{Ni = (YT/2) {1/Yn + XT(1 + IZr + YT/2 Yn)}}$$\text{Pi = XT (1 + IZr + YT/YN) - 1/Yn}$ Then, substitute f(X₁) for the left side of the formula 8), resulting in the following formula;${\text{f(X}}_{\text{1}} {\text{) = A6X}}_{\text{1}} {}^{\text{4}} {\text{+ A1X}}_{\text{1}} {}^{\text{3}} {\text{+ A2X}}_{\text{1}} {}^{\text{2}} {\text{+ A3X}}_{\text{1}} \text{+ A4}$
   Herein, it is possible to obtain X₁ maximizing f(X1).
   This value is X₁ which brings about a maximum value of IL in Y0 = Y1 = 1/2YT.
(ii) Y0 = 0, Y1 = YT (case 2))$\text{Y0 = 0, Y1 = YT}$
   For representing K using A4, substitute the formula 10) for the formulas 4) and 5) and then the result for the formula 6), resulting inproviding the following formula;${\text{f(X}}_{\text{1}} {\text{) = A0X}}_{\text{1}} {}^{\text{4}} {\text{+ A1X}}_{\text{1}} {}^{\text{3}} {\text{+ A2X}}_{\text{1}} {}^{\text{2}} {\text{+ A3X}}_{\text{1}} \text{+ A4}$ where,${\text{A0 = Mr}}^{\text{2}} {\text{+ Mi}}^{\text{2}}$$\text{A1 = 2(MrNr + MiNi)}$${\text{A2 = Nr}}^{\text{2}} {\text{+ Ni}}^{\text{2}} \text{+ 2MrPr + 2MiPi}$$\text{A3 = 2(NrPr - NiPi)}$${\text{A4 = Pr}}^{\text{2}} {\text{+ Pi}}^{\text{2}}$$\text{Mr = YTIZi}$$\text{Nr = YT(RN - XYIZi)}$$\text{Pr = RN(1 - YTXT) + XTIZi}$$\text{Mi = YT(1 + IZr)}$$\text{Ni = YT{1/Yn + Xt(1 + IZn)}}$$\text{Pi = XT(1 + IZr + YT/Yn) = 1/Yn}$

Like the (i) case, it is possible to obtain a value of X₁ which maximizes f(X₁). The X₁ is a value provided when Il maximizes under Y0 = 0 and Y1 = YT.

Under the same condition of YT and XT, comparing a maximum value of f(X₁) obtained from the formula 9) with that obtained from the formula 11) and picking up the circuit arrangement having a larger value, under F = 50 KHz, two areas appear, that is, (i) area where the C - L - C - L combination has a larger value of damping capacity IL and (ii) area where the L - C - L combination has a larger value. The border extends on the line where both combinations have the same IL value. Likewise, under F = 100 KHz, the border extends as shown in Fig. 4.

By providing a minimum frequency F and a certain CT and LT, therefore, it is possible to define filter arrangement having higher damping capacity with reference to the borders as shown in Figs. 3 and 4.

Once the filter arrangement is defined, it is also possible to obtain CX0 and CX1 from CT. Since the X₁ maximizing f(X₁) can be obtained with reference to the formulas 9) and 11), the following formulas compute L₁ and L₂.${\text{L}}_{\text{1}} {\text{= X}}_{\text{1}} {\text{/ω, L}}_{\text{2}} {\text{= (XT - X}}_{\text{1}} \text{)/ω}$

Figs. 3 and 4 show graphs plotting an approximation formula computing out a border in the form of;${\text{LT0 = a (b · CT)}}^{\text{-(dF + e)}}$ where a denotes a proportional factor of total inductance (= 2.39 x 10⁶), b denotes a proportional factor of total electrostatic capacitance (= 141), d denotes a proportional factor of a frequency (= 0.0132), e denotes a correction factor (= -1.055), and LT : µH, CT : µF, F : KHz.

By providing CT, LT and F, therefore, it is possible to select the combination of CX0 - L₁ - CX1 - L₂ if LT ≧ LT0 or the combination of L₁ - CX - L₂ if LT < LT0.

Reference has been heretofore directed to the line filter arrangement for attenuating normal mode noises. The line filter normally has a capability of attenuating common mode components, because the noise source generally includes common mode components.

The common mode choke coil for attenuating the common mode noises, included in the line filter arrangement as shown in Fig. 1, may serve to attenuate the normal mode noise components if it employs leak inductance. Fig. 5 shows line filter arrangement for normal mode noise components, which employs the common choke coil.

In Fig. 5, L₁ and L₂ denote inductors employing common mode choke coils, the leak inductance of which serves to suppress the normal mode noises. CX0, CX1 and CX2 denote capacitors for suppressing the normal mode noises.

Fig. 6 shows the filter arrangement for attenuating the normal mode noise components as well as the common mode noise components in cooperation with a Y capacitor.

In Fig. 6, CX1 and CX2 denote capacitors for suppressing the common mode noises. L₁ and L₂ denote inductors which respectively suppress the common mode noises using the common mode inductance and the normal mode noises using the leak inductance.

Further, G denotes an earth terminal which is part of a common noise path. CX0, CX1 and CX2 denote capacitors for suppressing the normal mode noises.

CX2 is an additive capacitor for attenuating the normal mode noises.

The foregoing description has been directed to a single line filter. It is also possible to dispersively locate L₁, L₂, CX0, CX1, CX2, CY1, and CY2 in a power supply or an electronic device.

As set forth above, the line filter of this embodiment comprises at least two normal mode inductors and at least one normal mode capacitor. Assuming that the total electrostatic capacitance is CT (µF), total inductance of the two inductors is LT (µH), a proportional factor of total inductance is a, a proportional factor of total capacitance is b, a proportional factor of a frequency is d, a correction factor of frequency is e, and a suppressed minimum frequency of a normal mode noise source is F (KHz), it is possible to select the combination of CX0 - L₁ - CX1 - L₂ if LT ≧ LT0 or the combination of L₁ - CX1 - L₂ if LT < LT0, where LT denotes total normal mode noise inductance and LT0 is given by the formula;${\text{LT0 = a (b x CT)}}^{\text{-(dF + e)}}$ The foregoing description results in offering definitive element constants.

Next, a value determining method for line filter components will be described.

Fig. 7 shows one embodiment of a line filter used for this method.

In Fig. 7, L₁ denotes a balun coil inserted on a power line on the input side, L₂ denotes a balun coil inserted on the power line on the load side, and Cₓ₁ denotes an X capacitor inserted on the power line on the input side of the balun coil L₂.

C_{y1} denotes a Y capacitor connected between the earth and power line on the load side of the balun coil L₁, C_{y2} denotes power line on the load side of the balun coil L₂, 1 and 1' denote input terminals to be connected to power lines, 2 and 2' denote output terminals to be connected to load lines, and G denotes an earth terminal connected to the earth of an AC-powered source.

In this circuit, the balun coil L₂ has a larger inductance than the balun coil L₁, and the Y capacitor C_{y2} has larger electrostatic capacitance than the Y capacitor C_{y1}.

As shown in Fig. 7, the circuit of this embodiment provides the X capacitor for suppressing the normal mode noises on a middle spot between the balun coils L₁ and L₂.

Fig. 8 shows the arrangement of a circuit to be compared with the circuit shown in Fig. 7.

In Fig. 8, an X capacitor Cₓ₀ is inserted between the power lines on the input side of the balun coil L₁, and an X capacitor Cₓ₁ is inserted between the power lines on the input side of the balun coil L₂. The other elements are common to those in the circuit shown in Fig. 7.

Then, reference will be directed to the process of forming the circuit shown in Fig. 1 with reference to Fig. 8.

Fig. 9 shows an equivalent circuit of the circuit shown in Fig. 7, which works for attenuating the normal mode noises.

In Fig. 9, I denotes switching current which generates the normal mode noises. C_{F} denotes a smoothing capacitor, which is a source of the switching current I.

R_{F} denotes an equivalent series resistor which is a parasitic element of the capacitor C_{F}, and Cₓ₀ and Cₓ₁ denote X capacitors connected between the power lines 1 and 1'.

L₁ₑ and L₂ₑ denote leak inductances of the balun coils L₁ and L₂, which provide impedance working as an obstacle against the normal mode noises. R_{N} denotes equivalent impedance of the LISN.

C_{N} denotes a high-pass filter capacitor which inhibits commercial frequency components and allows measuring noises to pass. Le and Re compose the remaining part of the LISN, which respectively correspond to a reactance element and a resistance element for correcting low-pass impedance.

3 and 3' denote terminals for picking up the normal mode noises and connecting to a disturbance waves level detector, V_{N} denote a voltage value of the normal mode noise components, and en denotes a voltage value of a source noise.

This circuit has a filter composed of L₁ₑ, L₂ₑ, Cₓ₀, and Cₓ₁. It serves to attenuate the noises generated in the equivalent series resistor R_{F} which is a parasitic element of the capacitor C_{F}.

In the circuit shown in Fig. 16, the X capacitor cₓ₁ is inserted between the power lines on the load side of the balun coil L₁, and the X capacitor Cₓ₂ is inserted between the power lines on the load side of the balun coil L₂. In the circuit shown in Fig. 2, the X capacitor Cₓ₀ is inserted between the power lines of the balun coil L₁, and the X capacitor Cₓ₁ is inserted between the power lines of the balun coil L₂.

The line filter employing the arrangement shown in Fig. 8 has a large attenuating effect for the normal mode noises. The present inventors detail this fact in the aforementioned Japanese Patent Specification filed on December 16, 1987.

The present invention discloses how to select the values of Cₓ₀, Cₓ₁, L₁ₑ, and L₂ₑ for making the line filter arrangement shown in Fig. 8 smaller and more lightweight.

At first, assuming that the waveform of I is 50 KHz (T = 20 µS), in Fig. 9, Cₓ₀ + Cₓ₁ = 0.47 µF (constant) is established in the values of;
Le 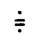 100 µH
Re 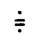 10 Ω
RN = 50
CN = 0.1 µ or less
CF = 27 µF or less
RF = 0.2 Ω
en = 0.163 V (50 KHz, Ton = 3.75 µS)
Vn = 2.118 mV (50 KHz)
and L₁ₑ = 0.2 mH is given, the process for obtaining a value of L₂ₑ will be described.

In Fig. 9, because of R_{F} » 1/ C_{F}, : switching frequency, the voltage en of the source noise can be represented by;${\text{en = R}}_{\text{F}} \sqrt{{\text{a(n)}}^{\text{2}} {\text{+ b(n)}}^{\text{2}}}$${\text{a(n) = I}}_{\text{2}} {\text{sin θ/nπ - (I}}_{\text{2}} {\text{-}}_{\text{I}} \text{) x (1 - cosθ)/nπθ}$${\text{b(n) = I}}_{\text{1}} {\text{/nπ - I}}_{\text{2}} {\text{cos θ/nπ + (I}}_{\text{2}} {\text{- I}}_{\text{1}} \text{) sinθ /nπθ} \text{= 2πnδ, δ = 0.5 Ei min/E}$

I₁ and I₂ respectively denote current values in the passage of switching current at the times of t = 0 and t - Ton.

Ei min denotes a minimum input voltage where pulse width of switching current is Ton = 1/2T. This is a minimum voltage which allows the pulse width to be controlled.

Assuming that an input voltage Ei = 280 V and Ei min = 105 V, the voltage en of the source noise is;
e(1) = 0.163 V for a fundamental wave (n = 1) shown in Fig. 10, or
e(2) = 0.1365 V, e(3) = 0.0983 V for a second or third high frequency. Assuming that
Cₓ₀, Cₓ₁ ≧ 0.1 µF
L₁ₑ, L₂ₑ ≧ 0.05 mH the values of filter components may be computed in relation to the fundamental wave only.

At the B level of VDE0871, the regulated value is;
Vn(1) = 2.118 mV (50 KHz, 55.6 dB)
Vn(2) = 1.20 mV (100 KHz, 61.6 dB) where by giving en (1), Vn(1), Cₓ₀ + Cₓ₁ = CT (= constant), and L₁ₑ, L₂ₑ is computed as follows.

Then, reference will be directed to several factors such as a current value or a voltage value in the circuit shown in Fig. 9, which factors are defined as shown in Fig. 11.

At first, flowing 1A through R_{N},${\text{Vn = 1(A) x 1/2R}}_{\text{N}} {\text{= 1/2 R}}_{\text{N}}$ is given. Then,
both terminals of Cₓ₀:${\text{VC}}_{\text{0}} {\text{= R}}_{\text{N}} \text{- jXn}$ current of Xe and Re:$\text{iz = Vco/(Re + jXe)} \text{= izr - jizi}$${\text{izr = (RNRe - XnXe)/(Re}}^{\text{2}} {\text{+ Xe}}^{\text{2}} \text{)}$${\text{izi = (RNXe + ReXn)/(Re}}^{\text{2}} {\text{+ Xe}}^{\text{2}} \text{)}$ current of Cₓ₀:${\text{ico = jω C}}_{\text{x0}} {\text{V}}_{\text{co}} {\text{= XnY}}_{\text{co}} {\text{+ jRnY}}_{\text{co}}$${\text{Y}}_{\text{co}} {\text{= ω C}}_{\text{x0}}$ current of L₁ₑ:${\text{i}}_{\text{Li}} {\text{= 1 + iz + i}}_{\text{co}}$${\text{i}}_{\text{Li}} {\text{= i}}_{\text{Lir}} {\text{+ ij}}_{\text{L1i}}$${\text{i}}_{\text{Lir}} {\text{= 1 + izr + XnY}}_{\text{co}}$${\text{i}}_{\text{L1i}} {\text{= RNY}}_{\text{co}} \text{- izi}$ voltage of L₁ₑ:${\text{V}}_{\text{L1}} {\text{= jω L}}_{\text{1e}} {\text{· I}}_{\text{Li}} \text{;}$${\text{V}}_{\text{1}} {\text{= ω L}}_{\text{1e}}$${\text{∴ V}}_{\text{L1}} {\text{= - X}}_{\text{Li}} {\text{i}}_{\text{L1}} {\text{i + jX}}_{\text{L1}} {\text{i}}_{\text{L1}} \text{r}$ voltage of Cₓ₁:${\text{V}}_{\text{c1}} {\text{= V}}_{\text{co}} {\text{+ V}}_{\text{L1}}$${\text{∴ V}}_{\text{c1}} {\text{= RN - X}}_{\text{L1}} {\text{i}}_{\text{L1}} \text{i} {\text{+ j(X}}_{\text{L1}} {\text{i}}_{\text{L1}} {\text{r - X}}_{\text{n}} \text{)}$ current of Cₓ₁:${\text{ic}}_{\text{1}} {\text{= j C}}_{\text{x1}} {\text{V}}_{\text{c1}} \text{;}$${\text{Y}}_{\text{c1}} {\text{= C}}_{\text{x1}}$${\text{∴ i}}_{\text{c1}} {\text{= - Y}}_{\text{c1}} {\text{V}}_{\text{c1}} \text{i} {\text{+ jY}}_{\text{c1}} {\text{iV}}_{\text{c1}} \text{r}$ current of L₂:${\text{i}}_{\text{L2}} {\text{= i}}_{\text{L1}} {\text{+ i}}_{\text{L1}} {\text{+ i}}_{\text{c1}}$${\text{∴ i}}_{\text{L2}} {\text{= i}}_{\text{L2}} {\text{r + ji}}_{\text{L2}} \text{i}$${\text{i}}_{\text{L2}} {\text{r = i}}_{\text{L1}} {\text{r + ic}}_{\text{1}} \text{r}$${\text{i}}_{\text{L2}} {\text{i = i}}_{\text{Li}} {\text{i + ic}}_{\text{1}} \text{i}$ voltage of L₂:${\text{V}}_{\text{L2}} {\text{= jω}}_{\text{L2}} {\text{ei}}_{\text{L2}} \text{;}$${\text{ω L2e = X}}_{\text{L2}}$${\text{V}}_{\text{L2}} {\text{= - X}}_{\text{L2}} {\text{i}}_{\text{L2}} {\text{i + jX}}_{\text{L2}} {\text{i}}_{\text{L2}} \text{r}$ source voltage:${\text{et = V}}_{\text{c1}} {\text{+ V}}_{\text{L2}}$$\text{∴ et = etr + jeti}$${\text{etr = V}}_{\text{c1}} {\text{r - X}}_{\text{L2}} {\text{i}}_{\text{L2}} \text{i}$${\text{eti = V}}_{\text{c1}} {\text{i + X}}_{\text{L2}} {\text{i}}_{\text{L2}} \text{r}$ By dividing both sides of all foregoing formulas with Rn, these formulas are transformed into the relation formulas of various amounts per 2Vn because of the given relation of RN = 2 Vn. Thus, assuming that (et/2Vn)² = (en/wVn)² = r and representing an unknown X_{L2} for obtaining L₂ₑ with x, x is given by the following formula;${\text{x = (ag - bf±√D)/(f}}^{\text{2}} {\text{+ g}}^{\text{2}} \text{)}$ where${\text{a = V}}_{\text{c1}} {\text{r, b = V}}_{\text{c1}} {\text{i, f = i}}_{\text{L2}} \text{r,}$${\text{g = i}}_{\text{L2}} \text{i,}$${\text{D = r(f}}^{\text{2}} {\text{+ g}}^{\text{2}} {\text{) - (ag + bg)}}^{\text{2}}$

Thus, by giving the source noise voltage en, the regulated values Vn, Cₓ₀, Cₓ₁ and L₁ₑ, L₂ₑ is given by;
L₂ₑ = x/ω
Assuming that L₁ₑ is 0.2 mH if Cₓ₀ + Cₓ₁ = CT = 0.47 µF, therefore, L₂ₑ can be computed out.

At the same time, the source noise fundamental wave voltage of R_{F} is 0.163 V, and Vn is given by;
Vn = 0.00118 V
in the state of the B level of the noise voltage regulated value VDE0871 at the measuring terminal R_{N} and at 50 KHz.

The damping capacity of the filter corresponds to (0.163/0.00118), where it is necessary to give L₂ₑ a value shown in Fig. 12.

Further, in Fig. 12, Ca denotes a value of Cₓ₀ (= 0 µF) minimizing L₂ₑ, and Cb denotes a value of Cₓ₀ (= 0.32 µF) locally minimizing L₂ₑ.

The smaller-sized line filter requires as small a value of L₂ₑ as possible. Hence, assuming that;
Cₓ₀ = Ca = 0 µF,
and
Cₓ₁ = 0.47 µF = Cₓ₀ = 0.47 µF,
L₂ₑ has a value given by;
L₂ₑ = 0.3 mH

In Fig. 12, Cₓ₀₁ and Cₓ₀₂ respectively denote a local maximum and a maximum value, which points respectively denote series resonance points between L₁ₑ//L₂ₑ (serial synthetic value of inductance) and Cx0 and between L₁ₑ and Cₓ₁.

Fig. 14 shows a characteristic curve of L₂ₑ depicted as a result of changing L₁ₑ in the range of 0.04 mH to 0.6 mH. The minimum value of L₂ₑ rests in case of;
Cₓ₀ = 0 µF, Cₓ₁ = 0.47 µF
Further, assuming that Cₓ₀ + Cₓ₁ = 0.68 µF is given, L₂ₑ has a minimum value in case of;
Cₓ₀ = 0 µF, Cₓ₁ = 0.68 µF
Then, increasing the value as shown below;
Cₓ₀ + Cₓ₁ = 1 µF
L₂ₑ has a minimal value on the following point as shown in Fig. 13; 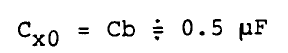 In case of Cₓ₀ + Cₓ₁ = 1 µF, under the state of L₁ₑ ≦ 0.2 mH, L₂ₑ has a minimal value when;
Cₓ₀ = Ca = 0 µF

g, h and i on Fig. 14 indicate characteristic curves of L₁ₑ depicted in relation to the foregoing minimal values of L₂ₑ. Each curve determines its required L₂ₑ if L₁ₑ is given in the state of;${\text{C}}_{\text{x0}} {\text{+ C}}_{\text{x1}} \text{= constant}$

These curves respectively coincide at points D, E and F with straight lines a, b and c which satisfy the condition of;${\text{L}}_{\text{1e}} {\text{+ L}}_{\text{2e}} \text{= constant}$ These points correspond to points minimizing the sum of
L₁ₑ + L₂ₑ
The characteristic curves g, h, i are depicted under the state of Cₓ₀ + Cₓ₁ = constant. Hence, each curve shows an optimal sum of the X capacitors.

The point of contact D, E or F indicates a minimal point of the choke coil. Hence, it shows optimal inductance.

The point of contact D, E or F means the point optimizing both the X capacitor and the choke coil. The k portion on the i curve means a section having a minimal value of L₂ₑ nearby; 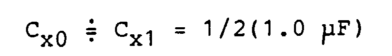 The portion satisfying the condition; L₁ₑ ≦ 0.26 mH is a point where L₂ₑ has a minimal value on the point of;
Cₓ₀ = 0, Cₓ₁ = 10 µF
These minimal points D, E, F satisfy the condition of;${\text{C}}_{\text{x0}} {\text{= 0, C}}_{\text{x1}} {\text{= max, L}}_{\text{1e}} {\text{< L}}_{\text{2e}}$

Lastly, reference will be directed to why the optimal point rests on the point of Cₓ₀ = 0.

If Cₓ₀ > 0, the circuit state approches a series resonance state caused by Cₓ₀ and Lₑ // L₁ₑ so that the noise voltage slightly rises between the terminal 1' and 1.

It means that lowering the noise voltage to the regulated value requires a larger value of L₂ₑ.

If a sum of Cₓ₀ + Cₓ₁ rises to about 1 uF, the L - C step type attenuating effect resulting from equally-divided 1 uF located on Cₓ₀ is more excellent than the attenuating effect resulting from 1 pF focused on Cₓ₁. As shown in Fig. 13, therefore L₂ₑ has a minimal value nearby;

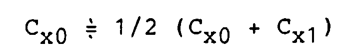

Fig. 15 shows the embodiment of the arrangement employing the foregoing phenomenon. This embodiment corresponds to the K section in Fig. 14 under the state of;${\text{C}}_{\text{x0}} {\text{= C}}_{\text{x1}} {\text{, L}}_{\text{1}} {\text{< L}}_{\text{2}}$

If the size of a choke coil is proportional to the energy amount E;${\text{E = 1/2 LI}}^{\text{2}} \text{(L: inductance, I: supply current)}$ condensed in the choke coil, the sum of two choke coils become minimal and most lightweight in the state of;${\text{E}}_{\text{1}} {\text{+ E}}_{\text{2}} {\text{= minimal or L}}_{\text{1e}} {\text{= L}}_{\text{2e}} \text{= minimal}$ The points D, E and F in Fig. 14 correspond to the points for the minimal and most lightweight choke coil, meeting the foregoing conditions. Further, the curve shown in Figs. 12 and 13 are based on the computation in the state of Cₓ₀ + Cₓ₁. Hence, by meeting the conditions of;
Cₓ₀ = 0, Cₓ₁ = max and Cₓ₀ = Cₓ₁ = 1/2 (max)
Cₓ₀ and Cₓ₁ are optimized. The point of the smallest and most lightweight X capacitor rests on the curve g, h or i shown in Fig. 14.

The circuit shown in Fig. 9 employs leak inductance of a balun type common mode choke coil as L₁ₑ and L₂ₑ, but it may employ an independent choke coil.

Considering that the balun type common mode choke coil has small normal mode inductance, the independent choke coil may be more advantageous.

If a shield is applied on a switching converter and transformer to attenuate the electrostatic capacitance between the primary coil and the secondary coil, the normal mode noises are more dominant. In this case, the circuits shown in Figs. 7 and 15 may employ a choke coil in place of a balun coil.

Though the foregoing description does not distinctively separate the inductance of the balun coil into the self-inductance L and leak inductance Le, the balun coil itself serves to attenuate the common mode noises using the self-inductance.

On the other hand, the leak inductance Le serves to suppress the normal mode noises.

The foregoing description employs Le for removing the normal mode noises and L for removing the common mode noises.

On order to determine the values of the choke coils L₁ₑ and L₂ₑ, this embodiment has the process of plotting a straight line having a minimal value of L₂ₑ as shown below;${\text{L}}_{\text{1e}} {\text{+ L}}_{\text{2e}} \text{= constant}$ and selecting a point of constant on the line or its near point.

Further, in order to select the values of the X capacitors Cₓ₀ andc Cₓ₁, under the condition of Cₓ₀ + Cₓ₁ = constant, it is possible to obtain a minimal value of L₂ₑ by giving a value of L₁ₑ or vice versa and then select a value of Cₓ₀ or Cₓ₁ corresponding to the minimal value or its near value.

It results in offering a line filter which is small and lightweight and has a high effect of attenuating the normal mode noises.

Further, the line filter of this invention offers a higher effect of attenuating the noises in a high-pass frequency, because the C_{y2} located on the conventional line filter works for the X capacitor for normal noises.

## Claims

1. A line filter to be used in an electronic apparatus having an AC input and a switching power source unit, comprising:
a first coil with a first inductance (L1) disposed in a line at an input side of said line filter;
a second coil with a second inductance (L2) disposed in the line at a load side of said line filter, the second coil connected in series with the first coil;
a third coil with the first inductance (L1) disposed on another line at the input side of said line filter;
a fourth coil with the second inductance (L2) disposed on the other line at the load side of said line filter, the fourth coil connected in series with the third coil; and
a first X capacitor of a first capacitance Cx1 disposed between a first node connecting said first coil with said second coil and a second node connecting said third coil with said fourth coil;
characterized by a second X capacitor of a second capacitance Cx0 disposed between the lines at the input side of said first coil and said third coil; wherein said first and third coils in combination exhibit a normal mode leak inductance of L1e, and said second and fourth coils in combination exhibit a normal mode leak inductance of L2e, L1e and L2e are such as to minimise their sum L1e+L2e for a given value of the sum Cx1+Cxo of the first and second capacitances; and wherein, for that given value of Cx1+Cxo, the second capacitance Cxo is such as to minimise (Ca, Figs. 12, 13), or locally to minimise (Cb, Figs. 12, 13), the second normal mode leak inductance L2e, on the basis of a relationship (Fig. 12, 13) between the second normal mode leak inductance L2e and the second capacitance Cx0; said relationship (Fig. 12, 13) having been determined on the basis of an analysis of a pseudo-power source circuit (Le, Re) connected to the input side, in an equivalent circuit of the line filter.

2. A line filter according to Claim 1, in which L1e=L2e.

3. A line filter according to Claim 1 or 2, for suppressing a frequency of at least F kilohertz, in which:
where a circuit constant Lt0=ab.Ct^{-(dF+e)} is greater than the total inductance Lt=L1+L2 measured in millihenries, the first X capacitor is the only capacitor between the said lines on the input side of the second and fourth coils;
and where the circuit constant Lt0 is less than the total inductance Lt, a second X capacitor (Cx0) is disposed between the lines on the input side of said first and third coils (L1), the capacitance of said second X capacitor being approximately equal to that of the first X capacitor;
where:
Ct is the sum of the capacitance of said first X capacitor and of any said second capacitor measured in microfarads;
a is a constant of proportionality equal to 2. 39 X 10E6;
b is a constant of proportionality equal to 141;
d is a frequency proportionality factor equal to 0. 0132; and
e is a frequency correction factor equal to -1.055.

4. A line filter according to Claim 3, comprising first Y capacitors (Cy1) disposed between ground and the first and second nodes on the load side of said first X capacitor.

5. A line filter according to Claim 4, comprising second Y capacitors (Cy2) disposed between the lines and ground on the load side of said second and fourth coils, the total capacitance of said second Y capacitors being larger than that of said first Y capacitors.

6. A line filter according to any preceding claim, wherein said first and said third coils are coils of a first balun.

7. A line filter according to any preceding claim, wherein said second and said fourth coils are coils of a second balun.

## Patentansprüche

1. Netzfilter, das in einer elektronischen Vorrichtung mit einem Wechselstromeingang und einer Schaltnetzteil zu verwenden ist, mit:
einer ersten Spule mit einer ersten Induktivität (L1), die in einer Leitung auf einer Eingangsseite des Netzfilters angeordnet ist;
einer zweiten Spule mit einer zweiten Induktivität (L2), die in einer Leitung auf einer Lastseite des Netzfilters angeordnet ist, wobei die zweite Spule mit der ersten Spule in Reihe geschaltet ist;
einer dritten Spule mit der ersten Induktivität (L1), die in einer anderen Leitung auf der Eingangsseite des Netzfilters angeordnet ist;
einer vierten Spule mit der zweiten Induktivität (L2), die in der anderen Leitung auf der Lastseite des Netzfilters angeordnet ist, wobei die vierte Spule mit der dritten Spule in Reihe geschaltet ist; und
einem ersten X-Kondensator mit einer ersten Kapazität Cx1, der zwischen einem ersten Knoten, der die erste Spule mit der zweiten Spule verbindet, und einem zweiten Knoten, der die dritte Spule mit der vierten Spule verbindet, angeordnet ist;
gekennzeichnet durch einen zweiten X-Kondensator mit einer zweiten Kapazität Cx0, der zwischen den Leitungen auf der Eingangseite der ersten Spule und der dritten Spule angeordnet ist; wobei die erste und die dritte Spule gemeinsam eine Gegentakt-Querinduktivität L1e darstellen und die zweite und die vierte Spule gemeinsam eine Gegentakt-Querinduktivität L2e darstellen, L1e und L2e so ausgeführt sind, daß ihre Summe L1e + L2e bei einem gegebenen Wert der Summe Cx1 + Cx0 aus der ersten und der zweiten Kapazität minimiert wird; und wobei bei diesem gegebenen Wert aus Cx1 + Cx0 die zweite Kapazität Cx0 so ausgeführt ist, daß die zweite Gegentakt-Querinduktivität L2e auf der Grundlage einer Beziehung (Fig. 12, 13) zwischen der zweiten Gegentakt-Querinduktivität L2e und der zweiten Kapazität Cx0 minimiert (Ca, Fig. 12, 13) oder lokal minimiert (Cb, Fig. 12, 13) wird; wobei die Beziehung (Fig. 12, 13) auf der Grundlage einer Analyse einer Pseudonetzteilschaltung (Le, Re), die mit der Eingangsseite verbunden ist, in einer Ersatzschaltung des Netzfilters bestimmt worden ist.

2. Netzfilter nach Anspruch 1, wobei gilt: L1e = L2e.

3. Netzfilter nach Anspruch 1 oder 2 zur Unterdrückung einer Frequenz von mindestens F Kilohertz, wobei gilt:
Wenn eine Schaltungskonstante Lt0 = ab·ct^{-(dF+e)} größer ist als die Gesamtinduktivität Lt = L1 + L2, gemessen in Millihenry, ist der erste X-Kondensator der einzige Kondensator zwischen den Leitungen auf der Eingangsseite der zweiten und der vierten Spule; und
wenn die Schaltungskonstante Lt0 kleiner ist als die Gesamtinduktivität Lt, wird ein zweiter X-Kondensator (Cx0) zwischen den Leitungen auf der Eingangsseite der ersten und der dritten Spule (L1) angeordnet, wobei die Kapazität des zweiten X-Kondensators annähernd gleich der des ersten X-Kondensators ist;
wobei gilt:
Ct ist die Summe der Kapazitäten des ersten X-Kondensators und irgendeines zweiten Kondensators, gemessen in Mikrofarad;
a ist eine Proportionalitätskonstante, die 2.39 x 10E6 entspricht;
b ist eine Proportionalitätskonstante, die 141 entspricht;
d ist ein Frequenzproportionalitätsfaktor, der 0.0132 entspricht; und
e ist ein Frequenzkorrekturfaktor, der -1.055 entspricht.

4. Netzfilter nach Anspruch 3 mit ersten Y-Kondesatoren (Cy1), die zwischen Masse und dem ersten und dem zweiten Knoten auf der Lastseite des ersten X-Kondensators angeordnet sind.

5. Netzfilter nach Anspruch 4 mit zweiten Y-Kondensatoren (Cy2), die zwischen den Leitungen und Masse auf der Lastseite der zweiten und der vierten Spule angeordnet sind, wobei die Gesamtkapazität der zweiten Y-Kondensatoren größer ist als die der ersten Y-Kondensatoren.

6. Netzfilter nach einem der vorhergehenden Ansprüche, wobei die erste und die dritte Spule Spulen eines ersten Symmetrieübertragers sind.

7. Netzfilter nach einem der vorhergehenden Ansprüche, wobei die zweite und die vierte Spule Spulen eines zweiten Symmetrieübertragers sind.

## Revendications

1. Filtre antiparasite à utiliser dans un appareil électronique comportant une entrée de courant alternatif et une unité d'alimentation à découpage, comprenant:
une première bobine présentant une première inductance (L1) disposée dans une ligne au niveau d'un côté d'entrée dudit filtre antiparasite;
une seconde bobine présentant une seconde inductance (L2) disposée dans la ligne au niveau d'un côté de charge dudit filtre antiparasite, la seconde bobine étant connectée en série à la première bobine;
une troisième bobine présentant la première inductance (L1) disposée sur une autre ligne au niveau du côté d'entrée dudit filtre antiparasite;
une quatrième bobine présentant la seconde inductance (L2) disposée sur l'autre ligne au niveau du côté de charge dudit filtre antiparasite, la quatrième bobine étant connectée en série à la troisième bobine; et
un premier condensateur X présentant une première capacité Cx1 disposé entre un premier noeud connectant ladite première bobine à ladite seconde bobine et un second noeud connectant ladite troisième bobine à ladite quatrième bobine,
caractérisé par un second condensateur X d'une seconde capacité Cx0 disposé entre les lignes au niveau du côté d'entrée de ladite première bobine et de ladite troisième bobine; dans lequel lesdites première et troisième bobines en combinaison présentent une inductance de fuite de mode normal de L1e et lesdites seconde et quatrième bobines en combinaison présentent une inductance de fuite de mode normal de L2e, L1e et L2e étant telles que leur somme L1e + L2e est minimisée pour une valeur donnée de la somme Cx1 + Cx0 des première et seconde capacités; et dans lequel, pour cette valeur donnée de Cx1 + Cx0, la seconde capacité Cx0 est telle qu'elle minimise (Ca, figures 12, 13) ou qu'elle minimise localement (Cb, figures 12, 13) la seconde inductance de fuite de mode normal L2e, sur la base d'une relation (figures 12, 13) entre la seconde inductance de fuite de mode normal L2e et la seconde capacité Cx0: ladite relation (figures 12, 13) ayant été déterminée sur la base d'une analyse d'un circuit de pseudo-alimentation (Le, Re) connecté au côté d'entrée, selon un circuit équivalent du filtre antiparasite.

2. Filtre antiparasite selon la revendication 1, dans lequel L1e = L2e.

3. Filtre antiparasite selon la revendication 1 ou 2, pour atténuer une fréquence d'au moins F kilohertz, dans lequel:
lorsqu'une constante de circuit Lt0 = ab·Ct^{-(dF+e)} est supérieure à l'inductance totale Lt = L1 + L2 mesurée en millihenrys, le premier condensateur X est le seul condensateur entre lesdites lignes sur le côté d'entrée des seconde et quatrième bobines: et
lorsque la constante de circuit Lt0 est inférieure à l'inductance totale Lt, un second condensateur X (Cx0) est disposé entre les lignes sur le côté d'entrée desdites première et troisième bobines (L1), la capacité dudit second condensateur X étant approximativement égale à celle du premier condensateur X;
où:
Ct est la somme de la capacité dudit premier condensateur X et de celle d'un quelconque dit second condensateur mesurées en microfarads;
a est une constante de proportionnalité égale à 2,39 x 10E6;
b est une constante de proportionnalité égale à 141;
d est un facteur de proportionnalité de fréquence égal à 0.0132; et
e est un facteur de correction de fréquence égal à -1,055.

4. Filtre antiparasite selon la revendication 3, comprenant des premiers condensateurs Y (Cy1) disposés entre la masse et les premier et second noeuds sur le côté de charge dudit premier condensateur X.

5. Filtre antiparasite selon la revendication 4, comprenant des seconds condensateurs Y (Cy2) disposés entre les lignes et la masse sur le côté de charge desdites seconde et quatrième bobines, la capacité totale desdits seconds condensateurs Y étant supérieure à celle desdits premiers condensateurs Y.

6. Filtre antiparasite selon l'une quelconque des revendications précédentes, dans lequel lesdites première et troisième bobines sont des bobines d'un premier symétriseur.

7. Filtre antiparasite selon l'une quelconque des revendications précédentes, dans lequel lesdites seconde et quatrième bobines sont des bobines d'un second symétriseur.
